(19) Europäisches Patentamt
European Patent Office
Office européen des brevets

(11) **EP 1 842 289 B1**

(12) **EUROPÄISCHE PATENTSCHRIFT**

(45) Veröffentlichungstag und Bekanntmachung des Hinweises auf die Patenterteilung:
**13.03.2013 Patentblatt 2013/11**

(21) Anmeldenummer: **05817220.6**

(22) Anmeldetag: **12.12.2005**

(51) Int Cl.:
**H03M 1/06** (2006.01)　　**H03M 1/18** (2006.01)

(86) Internationale Anmeldenummer:
**PCT/EP2005/056670**

(87) Internationale Veröffentlichungsnummer:
**WO 2006/074847 (20.07.2006 Gazette 2006/29)**

(54) **ANALOG-DIGITAL-UMSETZER**

ANALOG-DIGITAL CONVERTER

CONVERTISSEUR ANALOGIQUE-NUMERIQUE

(84) Benannte Vertragsstaaten:
**DE FR IT**

(30) Priorität: **14.01.2005 DE 102005001733**

(43) Veröffentlichungstag der Anmeldung:
**10.10.2007 Patentblatt 2007/41**

(73) Patentinhaber: **ROBERT BOSCH GMBH**
**70442 Stuttgart (DE)**

(72) Erfinder:
 • **BAUER, Wolfram**
 **72074 Tuebingen (DE)**
 • **LANG, Christoph**
 **Palo Alto, 94304 (CA)**

(56) Entgegenhaltungen:
WO-A-2004/006439　　FR-A- 2 529 043
SU-A1- 1 571 760　　US-A- 3 626 306
US-A- 3 858 200　　US-A- 4 246 571
US-A- 4 831 382　　US-A- 5 194 866
US-A1- 2002 149 507

• PATENT ABSTRACTS OF JAPAN Bd. 014, Nr. 163 (E-0910), 29. März 1990 (1990-03-29) -& JP 02 019025 A (YOKOGAWA ELECTRIC CORP), 23. Januar 1990 (1990-01-23)
• KIM D ET AL: "A SINGLE CHIP DELTA-SIGMA ADC WITH A BUILT-IN VARIABLE GAIN STAGE AND DAC WITH A CHARGE INTEGRATIN SUBCONVERTER FOR A 5 V 9600-B/S MODEM" IEEE JOURNAL OF SOLID-STATE CIRCUITS, IEEE SERVICE CENTER, PISCATAWAY, NJ, US, Bd. 30, Nr. 8, 1. August 1995 (1995-08-01), Seiten 940-943, XP000524393 ISSN: 0018-9200
• PATENT ABSTRACTS OF JAPAN Bd. 006, Nr. 060 (E-102), 17. April 1982 (1982-04-17) -& JP 57 002170 A (NEC CORP), 7. Januar 1982 (1982-01-07)

**Beschreibung**

Stand der Technik

Die Erfindung geht aus von einem Analog-Digital-Umsetzer mit einem analogen Eingangssignal und mit wenigstens einer Quantisierungsschwelle.

Zur Regelung analoger Größen bieten sich digitale Regler an, da sie folgende Vorteile besitzen: Die Zeitkonstanten sind digital einstellbar, wodurch sowohl Temperaturabhängigkeiten als auch Alterungen ausgeschlossen werden. Die Zeitkonstanten können beliebig groß gewählt werden. Der Einsatz externer Bauelemente zur Realisierung von großen Zeitkonstanten entfällt dabei. Somit werden die Systeme kostengünstig und die Robustheit gegenüber elektromagnetischen Strahlen steigt.

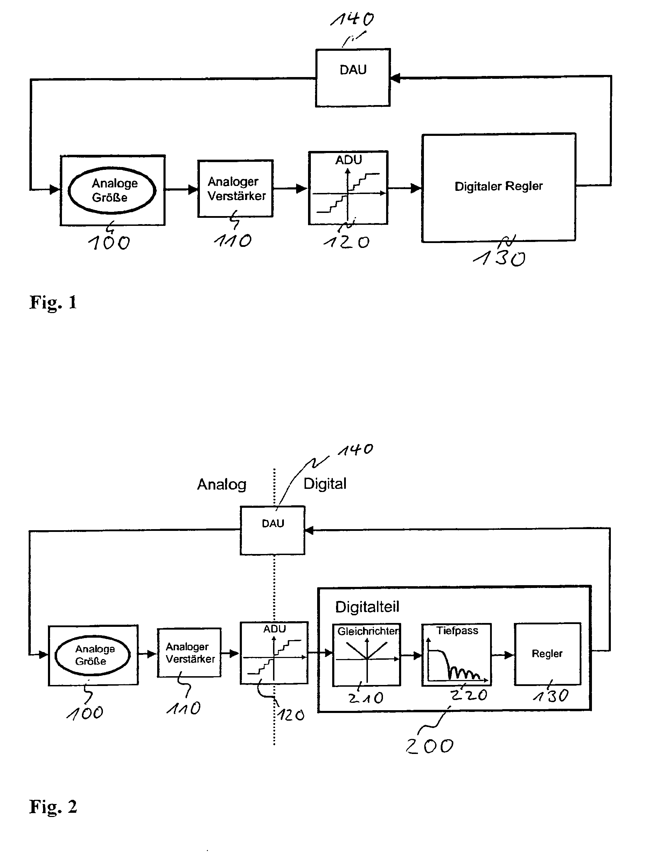

In Fig. 1 ist ein solcher Regelkreis in Form eines Prinzip-Blockschaltbildes dargestellt. Die digitale Regelung einer analogen Größe erfordert den Einsatz eines Analog-Digital-Umsetzers (ADU). Dieser vergleicht sein analoges Eingangssignal, welches über einen analogen Vorverstärker laufen kann, mit seinen Quantisierungsschwellen und gibt einen entsprechend quantisierten digitalen Wert aus. Dieser Digitalwert wird vom Regler verarbeitet und einem Digital-Analog-Umsetzer zugeführt, welcher mit seinem analogen Ausgangssignal auf die zu regelnde analoge Größe wirkt.

Diese Regelsysteme bergen jedoch einen Nachteil. Wenn das Eingangssignal des ADU sich zwischen zwei Quantisierungsschwellen befindet und sich so geringfügig ändert, dass keine weitere Quantisierungsschwelle überschritten wird, so reagiert auch der ADU nicht auf die Änderung des Eingangssignals. Die zu regelnde analoge Größe kann sich also ändern, ohne dass der digitale Regler eingreift. Erst wenn sich das analoge Signal so stark geändert hat, dass eine Quantisierungsschwelle des ADU überschritten wird, greift der digitale Regler ein. Es besteht nun die Gefahr, dass die zu regelnde analoge Größe zwischen zwei Quantisierungsschwellen des ADU hin und her geregelt wird, wodurch ein so genannter Grenzzyklus entsteht. Wenn die Frequenz dieses Grenzzyklus so klein ist, dass sie vom Ausgangsfilter des Systems nicht unterdrückt wird, führt der oben beschriebene Effekt zu Störungen im Ausgangssignal des Systems.

Eine Möglichkeit, die Amplitude des Grenzzyklus zu verkleinern, ist die Verkleinerung des Abstandes zwischen zwei Quantisierungsschwellen im ADU, wodurch der Quantisierungsfehler des ADU verkleinert wird. Bei gleich bleibendem Messbereich muss jedoch die Anzahl der Quantisierungsschwellen erhöht werden.

Auch wenn der ADU nicht in einem rückgekoppelten Regelsystem eingesetzt wird, besteht die Gefahr, dass das Eingangssignal des ADU sich zwischen zwei Schwellen ändert ohne dass der ADU mit einer Änderung seines Ausgangssignals reagiert. Man spricht dann von einer "Totzone".

Verschärft werden die Anforderungen an den ADU beim Wandeln von analogen Schwingungen mit hoher Frequenz. Zur Erfassung der hochfrequenten analogen Schwingung muss die Umsetzungsrate des ADU hoch sein. Hier bietet sich der Einsatz eines Flash-ADU an, welcher zu einem Zeitpunkt ein analoges Eingangssignal mit jeder seiner Quantisierungsschwellen vergleicht. Dies geschieht durch den Einsatz von Komparatoren, von denen jeder das Eingangssignal mit einer analogen Referenz vergleicht.

Ein mögliches Anwendungsbeispiel ist die Regelung einer hochfrequenten Schwingeramplitude mit vergleichsweise geringer Reglerbandbreite. Die analoge Schwingung wird hierbei von einem Flash-ADU ins Digitale gewandelt. Im Digitalen erfolgt dann die Gleichrichtung und anschließende Tiefpassfilterung. Dies ist in Fig. 2 dargestellt.

Aus der EP 0520 662 A2 zeigt einen ADU mit einem analogen Eingangssignal, mit wenigstens einer Quantisierungsschwelle, wobei der Analog-Digital-Umsetzer Mittel zur Änderung der wenigstens einen Quantisierungsschwelle aufweist. Dabei wird einer Quantisierungsschwelle ein kontinuierliches Rampensignal aufaddiert. Das digitale Ausgangssignal wird über mehrere Änderungen der Quantisierungsschwelle gemittelt, wodurch eine erhöhte Auflösung erzielt wird.

Die US 4246571 A offenbart einen Analog-Digital-Umsetzer mit einem analogen Eingangssignal, mit wenigstens einer Quantisierungsschwelle, wobei der Analog-Digital-Umsetzer Mittel zur Änderung der wenigstens einen Quantisierungsschwelle aufweist. Im Betrieb der beschriebenen Vorrichtung startet die Quantisierungsschwelle dabei von einem vorgegebenen Wert und wird iterativ derart geändert, dass sie möglichst dem analogen Eingangssignal gleicht. Aus den Dokumenten US 3858200 A, FR 2529043 A, US 6335698 A und DE 19626599 A sind ferner Regelungen bekannt, bei denen abhängig von der Größe des Eingangssignals oder Ausgangssignals eines ADU dessen Quantisierungsschwellen verändert werden.

Vorteile der Erfindung

Die Erfindung geht aus von einem Analog-Digital-Umsetzer mit einem analogen Eingangssignal und mit wenigstens einer Quantisierungsschwelle. Der Kern der Erfindung besteht darin, dass der Analog-Digital-Umsetzer Mittel zur Änderung der wenigstens einen Quantisierungsschwelle aufweist. Vorteilhaft ist hierbei, dass durch die Veränderung der Quantisierungsschwelle die Auflösung verändert werden kann.

Erfindungsgemäß vorgesehen ist, dass die Änderung der wenigstens einen Quantisierungsschwelle in einem normalen Betriebszustand möglich ist. Dadurch können Totzonen und Grenzzyklen verhindert werden.

Vorteilhaft ist weiterhin, dass der Analog-Digital-Umsetzer wenigstens zwei Quantisierungsschwellen aufweist und die Mittel zur Änderung wenigstens einer Quantisierungsschwelle derart ausgestaltet sind, dass der Wertunterschied zwischen den beiden Quantisierungsschwellen veränderbar ist.

Erfindungsgemäß vorgesehen ist, dass die Mittel zur Änderung wenigstens einer Quantisierungsschwelle derart ausgestaltet sind, dass eine gezielte Änderung der Quantisierungsschwelle um einen Mittelwert dargestellt ist. Durch Mittelung des digitalen Ausgangssignals über mehrere Änderungen der Quantisierungsschwelle können so Auswirkungen dieser Änderungen auf das digitale Ausgangssignal herausgefiltert werden.

Eine vorteilhafte Ausgestaltung der Erfindung sieht vor, dass die analog zu digital Umsetzung und/oder die Mittel zur Änderung wenigstens einer Quantisierungsschwelle von einem Takt gesteuert sind. Vorteilhaft können hierdurch erfindungsgemäß Flash-ADU eingesetzt und der Zeitpunkt der analog zu digital Umsetzung festgelegt werden. Dies ist im Hinblick auf zeitlich veränderliche, wie zum Beispiel hochfrequente periodische Signale vorteilhaft.

Vorteilhaft ist dabei insbesondere, dass das analoge Eingangssignal (U_ein) des Analog-Digital-Umsetzers ein periodisches Signal darstellt und der Takt (645) zu diesem periodischen Signal eine feste Phasenbeziehung aufweist.

Eine vorteilhafte Ausgestaltung der Erfindung sieht einen Analog-Digital-Umsetzer mit einer Anordnung von Komparatoren (K1,...K7) als Schwellenwertschalter, mit einer ersten Referenzspannung U_ref und mit einer Anordnung von Widerständen (R1,...,R6) zur Darstellung weiterer, aus der ersten Referenzspannung U_ref erzeugter Referenzspannungen für die Festlegung von Quantisierungsschwellen vor. Dabei sind die Mittel zur Änderung wenigstens einer Quantisierungsschwelle als steuerbare Widerstände (R1,...,R6) ausgebildet.

Eine andere vorteilhafte Ausgestaltung der Erfindung sieht einen Analog-Digital-Umsetzer mit einer Anordnung von Komparatoren (K1,...K7) als Schwellenwertschalter, mit einer ersten Referenzspannung U_ref und mit einer Anordnung von Widerständen (R1,...,R6) zur Darstellung weiterer, aus der ersten Referenzspannung U_ref erzeugter Referenzspannungen für die Festlegung von Quantisierungsschwellen vor. Dabei sind die Mittel zur Änderung wenigstens einer Quantisierungsschwelle als steuerbare Stromquelle (I_wuerfel), welche mit der Anordnung von Widerständen (R1,...,R6) verbunden ist, ausgebildet.

Um zum Beispiel in rückgekoppelten Regelsystemen oder beim Wandeln von analogen Schwingungen mit hoher Frequenz Grenzzyklen zu unterdrücken, ist die Erfindung vorteilhaft. Ein weiteres Einsatzgebiet der Erfindung ist eine digitale Nachlaufsynchronisation (PLL). Ferner bringt die Erfindung in Systemen, welche nicht rückgekoppelt sind, den Vorteil, dass die Totzonen des ADU verkleinert werden.

Erfindungsgemäß vorgesehen ist eine gezielte Variation der Verstärkung des Analog-Digital-Umsetzers (ADU) über der Zeit um einen Mittelwert (Verwürfelung), um hierdurch den mittleren Quantisierungsfehler des ADU zu verkleinern.

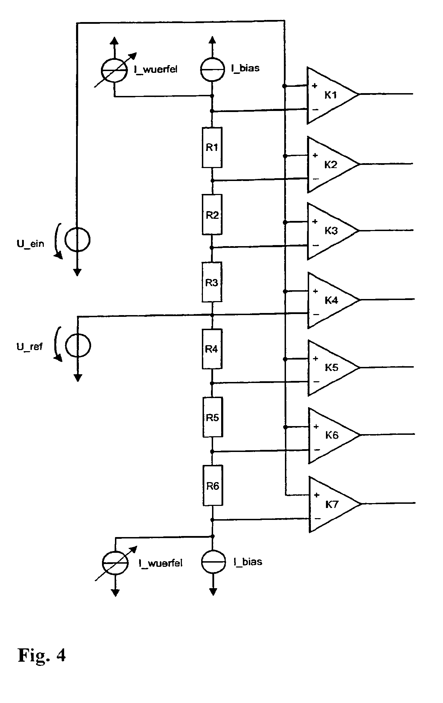

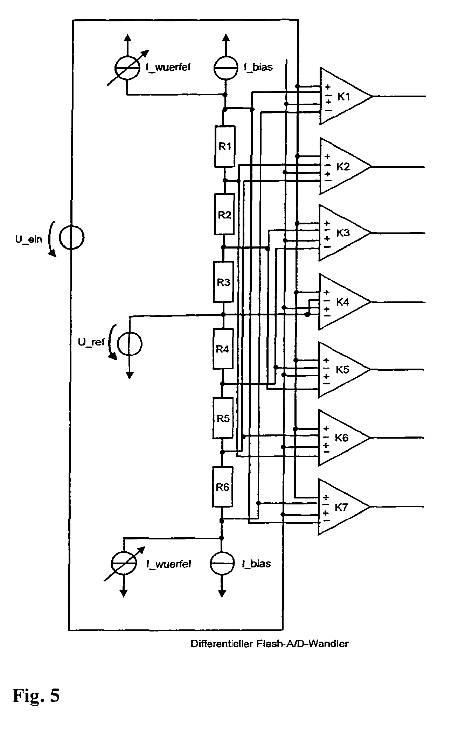

Eine vorteilhafte Ausgestaltung der Erfindung beinhaltet ein Schaltungsprinzip gemäß Fig. 4 zur Verwürfelung der Verstärkungen eines Flash-ADU. Vorteilhaft ist dabei eine Verstärkungsverwürfelung durch die einfach zu realisierende Verwürfelung des Stromes, der durch das in Fig. 4 dargestellte Widerstandsnetzwerk fließt. Vorteilhaft ist auch eine Verstärkungsverwürfelung durch den Einsatz von gesteuerten Widerständen im in Fig.4 dargestellten Widerstandsnetzwerk. Besonders vorteilhaft ist eine volldifferentielle Realisierung des in Fig.4 dargestellten Schaltungsprinzips wie in Fig. 5 gezeigt.

Eine vorteilhafte Ausgestaltung der Erfindung beinhaltet eine Filterung der Messergebnisse des ADU durch ein digitales Filter, um den Mittelwert des ADU-Ausgangssignals weiter verarbeiten zu können und den Einfluss der Verstärkungsverwürfelung auf das Ausgangssignal des Systems zu unterdrücken. Besonders vorteilhaft ist dabei eine Auslegung des digitalen Filters in der Art, dass es eine Nullstelle bei der Wiederholfrequenz der Änderung der Verstärkungen gibt.

Vorteilhaft ist die Ableitung der Taktfrequenz des digitalen Filters von der zu regelnden analogen Schwingung, wodurch sich die Frequenz der Nullstelle des digitalen Filters automatisch der Wiederholfrequenz der Verstärkungen anpasst und die Wirkung des Filters über Temperatur und auch über Lebensdauer immer optimal bleibt.

Vorteilhaft ist ein Einsatz eines erfindungsgemäßen Flash-ADU mit Verstärkungsverwürfelung in Systemen, in denen relativ niederfrequent eine Größe geregelt wird, welche von einer hochfrequenten Schwingung abhängt. Vorteilhaft ist insbesondere der Einsatz für eine digitale Amplitudenregelung und eine digitale Phasenregelung (PLL).

Eine vorteilhafte Ausgestaltung der Erfindung beinhaltet eine Einstellung der verschiedenen Werte der Verstärkungen des ADU in einer sich wiederholenden Abfolge von Verstärkungen derart, dass die Werte der Verstärkungen sich aus der Überlagerung von Verstärkungsfolgen verschiedener Frequenzen ergibt, wodurch die Amplitude eines Grenzzyklus reduziert wird und auf ein breites Frequenzspektrum geringer Störamplitude verteilt wird.

Weitere vorteilhafte Ausgestaltungen sind den Unteransprüche zu entnehmen.

Zeichnung

Ausführungsbeispiele der Erfindung sind in der Zeichnung dargestellt und in der nachfolgenden Beschreibung näher erläutert.

Fig. 1 zeigt eine digitale Regelung für analoge Signale mit Analog-Digital-Umsetzer.
Fig. 2 zeigt eine digitale Regelung für hochfrequente analoge Schwingungssignale mit Analog-Digital-Umsetzer.
Fig. 3 zeigt beispielhaft die Variation der Verstärkung durch einen erfindungsgemäßen Analog-Digital-Umsetzer.
Fig. 4 zeigt eine Ausführungsform des erfindungsgemäßen Analog-Digital-Umsetzers mit Komparatoren mit veränderbarer Referenzspannung.
Fig. 5 zeigt eine Ausführungsform des erfindungsgemäßen Analog-Digital-Umsetzers mit Komparatoren mit veränderbarer Referenzspannung volldifferentiell.
Fig. 6 zeigt schematisch einen digitalen Phasenregelkreis mit einem erfindungsgemäßen Analog-Digital-Umsetzer.

Beschreibung von Ausführungsbeispielen

Anhand der im Folgenden beschriebenen Ausführungsformen soll die Erfindung detailliert dargestellt werden.

Fig. 1 zeigt eine digitale Regelung für analoge Signale mit Analog-Digital-Umsetzer. Dargestellt ist ein solcher Regelkreis in Form eines Prinzip-Blockschaltbildes. Eine analoge Größe 100 erzeugt ein analoges Eingangssignal welches einem analogen Verstärker 110 zugeführt wird. Das verstärkte analoge Eingangssignal wird sodann einem Analog-Digital-Umsetzer (ADU) 120 zugeführt und in ein digitales Eingangssignal gewandelt. Das digitale Eingangssignal wird einem digitalen Regler 130 zugeführt, welcher daraus ein digitales Regelsignal generiert. Das digitale Regelsignal wird einem Digital-Analog-Umsetzer 140 zugeführt, welcher daraus ein analoges Regelsignal generiert. Das analoge Regelsignal wird wiederum der analogen Größe 100 zugeführt womit der Regelkreis geschlossen ist.

Die digitale Regelung einer analogen Größe erfordert den Einsatz eines Analog-Digital-Umsetzers ADU. Dieser vergleicht sein analoges Eingangssignal, welches über einen analogen Vorverstärker laufen kann, mit seinen Quantisierungsschwellen und gibt einen entsprechend quantisierten digitalen Wert aus. Dieser Digitalwert wird vom Regler verarbeitet und einem Digital-Analog-Umsetzer zugeführt, welcher mit seinem analogen Ausgangssignal auf die zu regelnde analoge Größe wirkt.

Derartige Regelsysteme weisen jedoch folgenden Nachteil auf. Wenn das Eingangssignal des ADU sich zwischen zwei Quantisierungsschwellen befindet und sich so geringfügig ändert, dass keine weitere Quantisierungsschwelle überschritten wird, so reagiert auch der ADU nicht auf die Änderung des Eingangssignals. Die zu regelnde analoge Größe kann sich also ändern ohne dass der digitale Regler eingreift. Erst wenn sich das analoge Signal so stark geändert hat, dass eine Quantisierungsschwelle des ADU überschritten wird, greift der digitale Regler ein. Es besteht nun die Möglichkeit, dass die zu regelnde analoge Größe zwischen zwei Quantisierungsschwellen des ADU hin und her geregelt wird, wodurch ein so genannter Grenzzyklus entsteht. Wenn die Frequenz dieses Grenzzyklus so klein ist, dass sie vom Ausgangsfilter des Systems nicht unterdrückt wird, führt der oben beschriebene Effekt zu Störungen im Ausgangssignal des Systems.

Eine Möglichkeit, die Amplitude des Grenzzyklus zu verkleinern, ist die Verkleinerung des Abstandes zwischen zwei Quantisierungsschwellen im ADU, wodurch der Quantisierungsfehler des ADU verkleinert wird. Bei gleich bleibendem Messbereich muss jedoch die Anzahl der Quantisierungsschwellen erhöht werden.

Auch wenn der ADU nicht in einem rückgekoppelten Regelsystem eingesetzt wird, besteht die Gefahr, dass das Eingangssignal des ADU sich zwischen zwei Schwellen ändert ohne dass der ADU mit einer Änderung seines Ausgangssignals reagiert. Man spricht dann von einer "Totzone".

Verschärft werden die Anforderungen an den ADU beim Wandeln von analogen Schwingungen mit hoher Frequenz. Zur Erfassung der hochfrequenten analogen Schwingung muss die Umsetzungsrate des ADU hoch sein. Hier bietet sich der Einsatz eines Flash-ADU an, welcher zu einem Zeitpunkt ein analoges Eingangssignal mit allen seiner Quantisierungsschwellen vergleicht. Dies geschieht durch den Einsatz von Komparatoren, von denen jeder das Eingangssignal mit einer analogen Referenz vergleicht. Zur Festlegung des Zeitpunktes, zu dem der Vergleich stattfindet, ist der Flash-ADU wie im Stand der Technik üblich getaktet.

Ein typisches Anwendungsbeispiel ist die Regelung einer hochfrequenten Schwingeramplitude mit vergleichsweise geringer Reglerbandbreite. Die analoge Schwingung wird hierbei von einem Flash-ADU ins Digitale gewandelt. Im Digitalen erfolgt dann die Gleichrichtung und anschließende Tiefpassfilterung. Fig. 2 zeigt beispielhaft eine digitale Regelung für hochfrequente analoge Schwingungssignale mit Analog-Digital-Umsetzer. Dargestellt ist ein erweiterter Regelkreis nach Fig. 1. Nach dem Analog-Digital-Umsetzer (ADU) 120 schließt sich im Signalpfad ein Digitalteil 200 an. Im Digitalteil 200 wird das digitale Regelsignal erzeugt, welches dem Digital-Analog-Umsetzer 140 zugeführt wird. Der Digitalteil 200 enthält im Signalpfad eingangsseitig einen Gleichrichter 210 welcher das Eingangssignal gleichrichtet. Anschließend folgt ein Tiefpaß 220 in dem das Signal gefiltert wird. Darauf folgt schließlich der digitale Regler 130 in dem das digitale Regelsignal erzeugt wird.

Um zum Beispiel in solchen Systemen Grenzzyklen zu unterdrücken, ist der erfindungsgemäße Analog-Digital-Umsetzer ADU geeignet. Ferner bringt die Erfindung in Systemen, welche nicht rückgekoppelt sind, den Vorteil, dass die Totzonen des ADU verkleinert werden.

Die erfindungsgemäße Ausgestaltung eines Analog-Digital-Umsetzers ADU beinhaltet, dass die Verstärkungen des ADU gezielt verwürfelt werden. Dies bedeutet, dass der ADU für einen vorgegebenen Zeitraum mit einer konstanten Verstärkung und den entsprechenden Lagen seiner Quantisierungsschwellen arbeitet. Nach Ablauf dieses Zeitraumes wird die Verstärkung im ADU geändert, indem die Lage seiner Quantisierungsschwellen um einen Faktor verschoben wird. Hier wird bevorzugt ein erfindungsgemäßer Flash-ADU verwendet. Mit dieser Verstärkungseinstellung wird der ADU nun wiederum über einen festen Zeitraum betrieben bis seine Verstärkung erneut umgeschaltet wird. Es ergibt sich also eine Folge von Verstärkungen, welche jeweils für einen begrenzten Zeitraum anliegen. Diese Folge von Verstärkungen wird um einen Mittelwert variieren und kann sich mit einer Frequenz wiederholen.

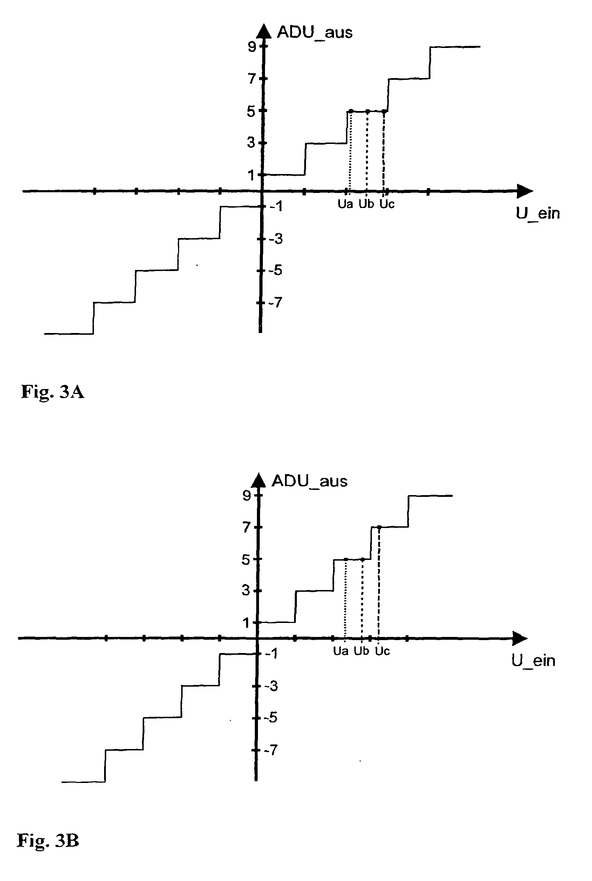

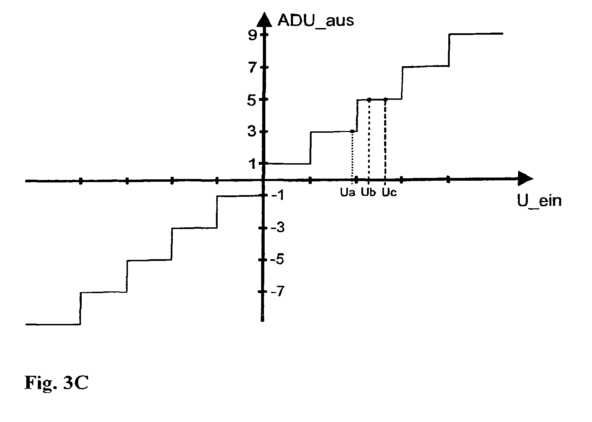

Fig. 3 zeigt beispielhaft die Variation der Verstärkung durch einen erfindungsgemäßen Analog-Digital-Umsetzer. Die Variation der Verstärkung kann erfindungsgemäß im normalen Betrieb des Analog-Digital-Umsetzers erfolgen, insbesondere auch außerhalb von Trimmvorgängen zur vorbereitenden Einstellung des Analog-Digital-Umsetzers. In den drei Diagrammen ist dargestellt, wie für einen konstanten Eingangswert am ADU durch Variation der Verstärkung des Umsetzers eine Verkleinerung des Quantisierungsfehlers und damit eine Erhöhung der Auflösung des ADU erreicht wird. Dazu ist der digitale Ausgangswert ADU_aus über der analogen Eingangsspannung U_ein aufgetragen.

In Fig. 3a ist beispielhaft die Kennlinie des ADU für eine mittlere Verstärkung dargestellt. Der digitale Ausgangswert des ADU "ADU_aus" ist über der Eingangsspannung des ADU "U_ein" aufgetragen. Bei dieser mittleren Verstärkung des Umsetzers reagiert der ADU für die drei verschiedenen Eingangsspannungen Ua, Ub und Uc mit dem gleichen digitalen Ausgangswert (5).

Wird der Abstand zwischen den Quantisierungsschwellen um 10% reduziert, so steigt die Verstärkung des ADU entsprechend. Die resultierende Kennlinie ist in Fig. 3b dargestellt. Gemäß dieser Kennlinie reagiert der ADU für die Eingangsspannungen Ua und Ub mit dem Digitalwert 5 und für die Eingangsspannung Uc mit dem Digitalwert 7.

In Fig. 3c ist die Wandlerkennlinie für eine geringe Verstärkung des ADU dargestellt. In diesem Fall ist der Abstand der Quantisierungsschwellen um 10% vergrößert. Der ADU reagiert für die Eingangsspannung Ua mit dem Digitalwert 3 und für die Eingangsspannungen Ub und Uc mit dem Digitalwert 5.

Wird nun erfindungsgemäß für jede der drei verschiedenen Eingangsspannungen (Ua, Ub und Uc) der Mittelwert des entsprechenden ADU-Ausganges gebildet, so unterscheiden sich die Mittelwerte (Ua: 4,33 ;Ub: 5; Uc: 5,66) aufgrund der verwürfelten, d.h. der in geeigneter Abfolge veränderten ADU-Verstärkungen, wodurch der mittlere Quantisierungsfehler des ADU vermindert wird, die Auflösung des Wandlers erhöht wird und somit in einem Regelkreis Grenzzyklen unterdrückt werden können.

Stellt das Eingangssignal des ADU eine analoge Schwingung dar und wird für jeweils eine Periodendauer dieser Schwingung eine konstante Verstärkung eingestellt, so kann durch die hohe Abtastrate des ADU die Signalform inklusive Nulldurchgang erkannt werden. Die Mittelung über mehrere Periodendauern mit mehreren verschiedenen ADU-Verstärkungen erhöht die Auflösung bezüglich der Amplitude. Eine Änderung der Schwingeramplitude kann somit früher erkannt werden und führt zu einer früheren Änderung des Eingangssignals des Reglers welcher schon eingreifen kann bevor ein Grenzzyklus entsteht.

Ein weiteres Einsatzgebiet für einen erfindungsgemäßen Analog-Digital-Umsetzer ist eine digitale Nachlaufsynchronisation PLL wie weiter unten dargestellt.

Die Frequenz mit der sich die verschiedenen Verstärkungen des ADU wiederholen, muss so dimensioniert werden, dass sie oberhalb der Bandbreite des digitalen Regelkreises liegt. Hierdurch wird gewährleistet, dass die Verwürfelung der ADU-Verstärkungen sich nicht störend auf die zu regelnde analoge Größe auswirkt.

Eine weitere Ausgestaltung der Erfindung besteht darin, wie in Fig. 2 gezeigt ein digitales Filter im Regler einzusetzen, welches bei der Wiederholfrequenz der ADU-Verstärkungen eine Nullstelle hat, um die störende Wirkung der Verstärkungsverwürfelung auf das zu regelnde Analogsignal zu minimieren.

Eine weitere Ausgestaltung der Erfindung besteht darin, die Taktfrequenz dieses Filters von der zu regelnden analogen Schwingung abzuleiten, wodurch sich die Frequenz der Nullstelle des digitalen Filters automatisch der Wiederholfrequenz der Verstärkungen anpasst und die Wirkung des Filters über Temperatur und auch über Lebensdauer immer optimal bleibt. Dies ist zum Beispiel für eine digitale PLL sehr gut geeignet wie weiter unten ausgeführt.

Eine weitere Ausgestaltung der Erfindung besteht darin, zur Vermeidung von Grenzzyklen die Verstärkungen des ADU nicht nur mit einer einzigen Frequenz zu verwürfeln. Die zeitliche Abfolge der Amplituden der ADU-Verstärkung kann auch bestimmt werden indem verschiedene Folgen, in denen sich die Verstärkungen mit verschiedenen Frequenzen wiederholen, addiert werden. Die resultierende Abfolge von Verstärkungen stellt dann ein Frequenzgemisch von Verstärkungen dar. Hierdurch wird die Ausbildung eines Grenzzyklus mit einer einzigen Frequenz weiter erschwert. Statt die Störamplitude des zu unterdrückenden Grenzzyklus auf eine Frequenz zu konzentrieren, werden die Störungen auf ein breiteres Frequenzspektrum mit geringeren Amplituden verteilt.

Im Folgenden ist eine beispielhafte Ausführungsform eines erfindungsgemäßen Analog-Digital-Umsetzers ADU dargestellt. Fig. 4 zeigt eine Ausführungsform des erfindungsgemäßen Analog-Digital-Umsetzers mit Komparatoren mit veränderbarer Referenzspannung.

Der beispielhaft dargestellte Analog-Digital-Umsetzer ADU besteht aus sieben Komparatoren K1 bis K7, an welchen am negativen Eingang jeweils eine individuelle Referenzspannung anliegt. Diese Referenzspannungen stellen die Quantisierungsschwellen dar mit denen das Eingangssignal U_ein des Wandlers verglichen wird. Die Referenzspannungen können folgendermaßen erzeugt werden.

Die Referenzspannung des mittleren Komparators K4 wird von einer Referenzspannungsquelle U_ref bereitgestellt. Ein Widerstandsnetzwerk, bestehend aus den Widerständen R1 bis R6, wird von einem Strom durchflossen, der sich aus den beiden Teilströmen I_bias und 1_wuerfel zusammensetzt. Diese Ströme werden von Stromquellen bereitgestellt, welche an den Widerstand R1 angreifen. Die beiden Stromsenken I_bias und I_wuerfel, welche an R6 angreifen, leiten den von den Stromquellen gelieferten Strom gegen Masse ab. Dementsprechend ergibt sich beispielsweise am negativen Eingang des Komparators K2 die Referenzspannung:

$$U\_refK2 = U\_ref + (1\_bias + 1\_wuerfel)*(R2 + R3).$$

Werden die Parameter U_ref, I_bias sowie alle Widerstandswerte konstant gehalten, so können über den Parameter I_wuerfel die Referenzspannungen und somit die Verstärkungen des ADU gezielt verwürfelt (geändert) werden. Dies kann mit einem Eingangssignal oder einer Ansteuerschaltung für I_wuerfel erzielt werden (nicht dargestellt). Das Eingangssignal oder die Ansteuerschaltung können getaktet sein. Alternativ zu der in Fig. 4 dargestellten Verwürfelung der Referenzspannung mittels eines Verwürfelungsstromes I_wuerfel können auch schaltbare Widerstände eingesetzt werden, die ebenfalls mittels einer Ansteuerschaltung steuerbar sind. Nach einer bestimmten Abfolge von Verstärkungen des ADU sollte die Verstärkung im Mittel über diese gesamte Abfolge einen festen Wert annehmen.

Dieses Schaltungsprinzip zeichnet sich durch die sehr einfache Realisierbarkeit und den sehr geringen Flächenbedarf aus. Außerdem ist dieses Schaltungsprinzip auch auf volldifferentielle Schaltungsrealisierungen übertragbar. Fig. 5 zeigt dazu eine Ausführungsform des erfindungsgemäßen Analog-Digital-Umsetzers mit Komparatoren mit veränderbarer Referenzspannung volldifferentiell. Die Schaltelemente sind aus Fig. 4 bekannt und arbeiten hier sinngemäß.

Zur Festlegung des Zeitpunktes, zu dem der Vergleich stattfindet, ist der erfindungsgemäße Analog-Digitalwandler, wie er beispielhaft in den Fig. 4 und 5 beschrieben ist, als Flash-ADU ausgestaltet und kann dann wie im Stand der Technik üblich getaktet sein (nicht dargestellt).

Eine weitere Möglichkeit, die Verstärkung des ADU zu verändern, besteht darin, die Werte der Widerstände im Referenzteiler des ADU zu verändern. Dies kann durch Einsatz von gesteuerten Widerständen, wie zum Beispiel Feldeffekttransistoren geschehen. Dies stellt eine und damit eine andere Ausgestaltung der Erfindung dar.

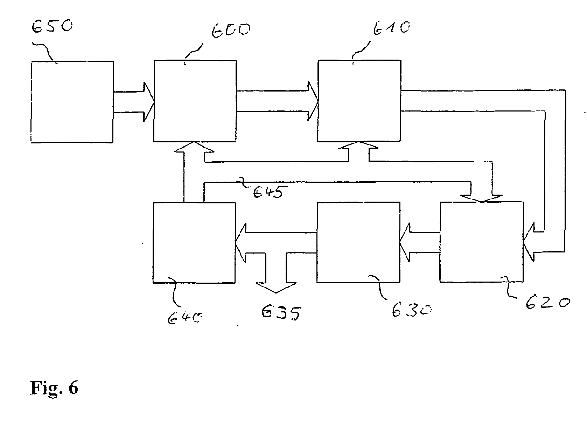

Ein weiteres Einsatzgebiet für einen erfindungsgemäßen Analog-Digital-Umsetzer ist eine digitale Nachlaufsynchronisation PLL. Fig. 6 zeigt dazu schematisch einen digitalen Phasenregelkreis mit einem erfindungsgemäßen Analog-Digital-Umsetzer. Ein Flash-ADU 600 erfasst an seinem Eingang das Spannungssignal 650 einer analogen Schwingung. Der Phasenregelkreis PLL umfasst weiterhin einen Phasen- und Frequenz-detektor 610, ein Schleifenfilter 620 eine Funktionsgruppe 630 mit einem Digital-Analog-Umsetzer (DAU) und einem spannungsgesteuerten Oszillator (VCO), sowie eine Teiler 640. Der spannungsgesteuerte Oszillator (VCO) erzeugt einen Systemtakt 635, welcher im Teiler 640 in ein niederfrequentes Taktsignal 645 heruntergetaktet wird. Das Taktsignal 645 wird den Komponenten des Phasenregelkreises PLL zugeführt. Der Flash ADU 600 wird mit dem Taktsignal 645 getaktet wobei das Taktsignal eine höhere Frequenz als das Spannungssignal 650 aufweist, derart dass das Abtasttheorem erfüllt ist.

Der Phasenregelkreis PLL synchronisiert auf das Spannungssignal 650 der analogen Schwingung am Eingang des ADU. Digitale Filter wie der unter Fig. 2 beschriebene Tiefpaß werden mit dem an der PLL abgeleiteten Systemtakt 635 betrieben. Damit ändern sich alle Filtereigenschaften (wie z.B. Nullstellen) mit der analogen Schwingung 650.

Der erfindungsgemäße Flash ADU ist insbesondere dazu geeignet einen Phasenregelkreis aufzubauen, wie er in der deutschen Offenlegungsschrift DE 102 47 996 A1 offenbart ist.

Es sind daneben auch weitere Ausführungsbeispiele denkbar.

**Patentansprüche**

**1.** Analog-Digital-Umsetzer

    - mit einem analogen Eingangssignal (U_ein)
    - mit wenigstens einer Quantisierungsschwelle,
    - wobei der Analog-Digital-Umsetzer Mittel zur Änderung wenigstens einer Quantisierungsschwelle aufweist, welche derart ausgestaltet sind, dass die Änderung der wenigstens einen Quantisierungsschwelle in einem normalen Betriebszustand möglich ist,

- wobei eine gezielte Änderung der Quantisierungsschwelle um einen vorgegebenen Mittelwert der Quantisierungsschwelle dargestellt ist,

- und wobei das digitale Ausgangssignal über mehrere Änderungen der Quantisierungsschwelle gemittelt wird,

**dadurch gekennzeichnet, dass**

- der Analog-Digital-Umsetzer als Flash-Analog-Digital-Umsetzer mit wenigstens zwei Quantisierungsschwellen ausgebildet ist, und dass

- die Mittel zur Änderung wenigstens einer Quantisierungsschwelle als eine gezielte Verwürfelung der Verstärkung des Flash-Analog-Digital-Umsetzers ausgebildet sind, indem eine Folge von Verstärkungen vorgesehen ist, welche jeweils für einen begrenzten Zeitraum anliegen.

2. Analog-Digital-Umsetzer nach Anspruch 1, **dadurch gekennzeichnet, dass** die Mittel zur Änderung wenigstens einer Quantisierungsschwelle derart ausgestaltet sind, dass der Wertunterschied zwischen den beiden Quantisierungsschwellen veränderbar ist.

3. Analog-Digital-Umsetzer nach Anspruch 1, **dadurch gekennzeichnet, dass** die analog zu digital Umsetzung und/ oder die Mittel zur Änderung wenigstens einer Quantisierungsschwelle von einem Takt (645) gesteuert sind.

4. Analog-Digital-Umsetzer nach Anspruch 3, **dadurch gekennzeichnet, dass** das analoge Eingangssignal (U_ein) des Analog-Digital-Umsetzers ein periodisches Signal darstellt und der Takt (645) zu diesem periodischen Signal eine feste Phasenbeziehung aufweist.

5. Analog-Digital-Umsetzer nach einem der vorhergehenden Ansprüche 1 bis 4,

- mit einer Anordnung von Komparatoren (K1,... K7) als Schwellenwertschalter
- mit einer ersten Referenzspannung U_ref
- mit einer Anordnung von Widerständen (R1,...,R6) zur Darstellung weiterer, aus der ersten Referenzspannung U_ref erzeugter Referenzspannungen für die Festlegung von Quantisierungsschwellen, **dadurch gekennzeichnet, dass** die Mittel zur Änderung wenigstens einer Quantisierungsschwelle als steuerbare Widerstände (R1,..., R6) ausgebildet sind.

6. Analog-Digital-Umsetzer nach einem der vorhergehenden Ansprüche 1 bis 4,

- mit einer Anordnung von Komparatoren (K1,...K7) als Schwellenwertschalter
- mit einer ersten Referenzspannung U_ref
- mit einer Anordnung von Widerständen (R1,...,R6) zur Darstellung weiterer, aus der ersten Referenzspannung U_ref erzeugter Referenzspannungen für die Festlegung von Quantisierungsschwellen, **dadurch gekennzeichnet, dass** die Mittel zur Änderung wenigstens einer Quantisierungsschwelle als steuerbare Stromquelle (I_wuerfel), welche mit der Anordnung von Widerständen (R1,...,R6) verbunden ist, ausgebildet sind.

**Claims**

1. Analogue/digital converter

- having an analogue input signal (U_ein),
- having at least one quantization threshold,
- the analogue/digital converter having means for changing at least one quantization threshold, which means are configured in such a manner that it is possible to change the at least one quantization threshold in a normal operating state,
- the quantization threshold being changed in a targeted manner by a predefined average value of the quantization threshold,
- and the digital output signal being averaged over a plurality of changes of the quantization threshold,

**characterized in that**

- the analogue/digital converter is in the form of a flash analogue/digital converter having at least two quantization thresholds, and **in that**
- the means for changing at least one quantization threshold are designed as targeted scrambling of the gain of the flash analogue/digital converter by providing a sequence of gains which are each present for a limited period of time.

2. Analogue/digital converter according to Claim 1, **characterized in that** the means for changing at least one quantization threshold are configured in such a manner that the difference in value between the two quantization thresholds can be changed.

3. Analogue/digital converter according to Claim 1, **characterized in that** the analogue/digital conversion and/or the means for changing at least one quantization threshold is/are controlled by a clock (645).

4. Analogue/digital converter according to Claim 3, **characterized in that** the analogue input signal (U_ein) of the analogue/digital converter is a periodic signal, and the clock (645) has a fixed phase relationship with respect to this periodic signal.

5. Analogue/digital converter according to one of the preceding Claims 1 to 4,

- having an arrangement of comparators (K1,...K7) as a threshold value switch,
- having a first reference voltage U_ref,
- having an arrangement of resistors (R1,...,R6) for constituting further reference voltages for determining quantization thresholds, which further reference voltages are generated from the first reference voltage U_ref, **characterized in that** the means for changing at least one quantization threshold are in the form of controllable resistors (R1,...,R6).

6. Analogue/digital converter according to one of the preceding Claims 1 to 4,

- having an arrangement of comparators (K1,...K7) as a threshold value switch,
- having a first reference voltage U_ref,
- having an arrangement of resistors (R1,...,R6) for constituting further reference voltages for determining quantization thresholds, which further reference voltages are generated from the first reference voltage U_ref, **characterized in that** the means for changing at least one quantization threshold are in the form of a controllable current source (I_wuerfel) which is connected to the arrangement of resistors (R1,...,R6).

**Revendications**

1. Convertisseur analogique/numérique

- comprenant un signal d'entrée analogique (U_ein)
- comprenant au moins un seuil de quantification,
- le convertisseur analogique/numérique présentant des moyens pour modifier au moins un seuil de quantification, lesquels sont configurés de telle sorte que la modification de l'au moins un seuil de quantification est possible dans un état de fonctionnement normal,
- une modification visée du seuil de quantification d'une valeur moyenne prédéfinie du seuil de quantification étant représentée,
- et la moyenne du signal de sortie numérique étant calculée sur plusieurs modifications du seuil de quantification,

**caractérisé en ce que**

- le convertisseur analogique/numérique est réalisé sous la forme d'un convertisseur analogique/numérique flash disposant d'au moins deux seuils de quantification et **en ce que**
- les moyens pour modifier au moins un seuil de quantification sont réalisés sous la forme d'un brouillage ciblé de l'amplification du convertisseur analogique/numérique flash en prévoyant une série d'amplifications qui sont respectivement appliquées pendant une période limitée.

2. Convertisseur analogique/numérique selon la revendication 1, **caractérisé en ce que** les moyens pour modifier au moins un seuil de quantification sont configurés de telle sorte que la différence de valeur entre les deux seuils de quantification peut être modifiée.

3. Convertisseur analogique/numérique selon la revendication 1, **caractérisé en ce que** la conversion d'analogique en numérique et/ou les moyens pour modifier au moins un seuil de quantification sont commandés par une horloge (645).

4. Convertisseur analogique/numérique selon la revendication 3, **caractérisé en ce que** le signal d'entrée analogique (U_ein) du convertisseur analogique/numérique représente un signal périodique et l'horloge (645) présente une relation de phase fixe par rapport à ce signal périodique.

5. Convertisseur analogique/numérique selon l'une des revendications précédentes 1 à 4,

   - comprenant un arrangement de comparateurs (K1, ..., K7) sous la forme d'un commutateur de valeur de seuil,
   - comprenant une première tension de référence U_ref
   - comprenant un arrangement de résistances (R1, ..., R6) pour la représentation de tensions de référence supplémentaires générées à partir de la première tension de référence U_ref pour la définition des seuils de quantification,

   **caractérisé en ce que** les moyens pour modifier au moins un seuil de quantification sont réalisés sous la forme de résistances commandables (R1, ..., R6).

6. Convertisseur analogique/numérique selon l'une des revendications précédentes 1 à 4,

   - comprenant un arrangement de comparateurs (K1, ..., K7) sous la forme d'un commutateur de valeur de seuil,
   - comprenant une première tension de référence U_ref
   - comprenant un arrangement de résistances (R1, ..., R6) pour la représentation de tensions de référence supplémentaires générées à partir de la première tension de référence U_ref pour la définition des seuils de quantification,

   **caractérisé en ce que** les moyens pour modifier au moins un seuil de quantification sont réalisés sous la forme d'une source de courant (I_wuerfel) commandable qui est reliée avec l'arrangement de résistances (R1, ..., R6).

140

DAU

Analoge
Größe

Analoger
Verstärker

ADU

Digitaler Regler

100

110

120

130

**Fig. 1**

140

Analog | Digital

DAU

Digitalteil

Analoge
Größe

Analoger
Verstärker

ADU

Gleichrichter

Tiefpass

Regler

100

110

120

210

220

130

200

**Fig. 2**

Fig. 3A

Fig. 3B

**Fig. 3C**

Fig. 4

Differentieller Flash-A/D-Wandler

**Fig. 5**

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0520662 A2
- US 4246571 A
- US 3858200 A
- FR 2529043 A
- US 6335698 A
- DE 19626599 A
- DE 10247996 A1